**Europäisches Patentamt**

**European Patent Office**

**Office européen des brevets**

(19)

(11) Veröffentlichungsnummer: **0 062 883**

**B1**

(12)

# EUROPÄISCHE PATENTSCHRIFT

(45) Veröffentlichungstag der Patentschrift:
23.07.86

(21) Anmeldenummer: **82102922.0**

(22) Anmeldetag: **06.04.82**

(51) Int. Cl.⁴: **H 01 L 21/265**

(54) **Verfahren zur Herstellung eines integrierten bipolaren Planartransistors.**

(30) Priorität: **14.04.81 DE 3115029**

(43) Veröffentlichungstag der Anmeldung:
**20.10.82 Patentblatt 82/42**

(45) Bekanntmachung des Hinweises auf die Patenterteilung:
**23.07.86 Patentblatt 86/30**

(84) Benannte Vertragsstaaten:
**DE FR GB IT NL**

(56) Entgegenhaltungen:
**DE-A-2 725 095**

(73) Patentinhaber: **Deutsche ITT Industries GmbH, Hans- Bunte- Strasse 19 Postfach 840, D-7800 Freiburg (DE)**
(84) Benannte Vertragsstaaten: **DE**

(73) Patentinhaber: **ITT INDUSTRIES INC., 320 Park Avenue, New York, NY 10022 (US)**
(84) Benannte Vertragsstaaten: **FR GB IT NL**

(72) Erfinder: **Gahle, Hans- Jürgen, Dr. Ing., Panoramastrasse 13, D-7830 Emmendingen (DE)**

(74) Vertreter: **Morstadt, Volker, Dipl.- Ing., c/o Deutsche ITT Industries GmbH Patent/Lizenzabteilung Postfach 840 Hans- Bunte- Strasse 19, D-7800 Freiburg/Brsg. (DE)**

## Beschreibung

Die Erfindung betrifft ein Verfahren gemäß dem Oberbegriff des Anspruchs 1, wie es aus der EP-OS 0 002 661 bekannt ist. Bei diesem bekannten Verfahren werden vor einem abschließenden Erwärmungsprozess zwischen 900° C und 1100° C zur Ausheilung der Gitterstörungen unter Aktivierung der Dotierungen sowohl das Dotierungsmaterial der Basiszone als auch das der Emitterzone in die Halbleiteroberfläche eingebracht. Da außerdem die anfänglich aufgebrachte Isolierschicht zumindest im Bereich der Leitbahnenmetallisierung entgültig auf der Halbleiteroberfläche verbleibt und keine Reoxidation erfolgt, ergeben sich relativ geringe Schwankungen der Zuleitungskapatizäten.

Das bekannte Verfahren hat aber den Nachteil, daß die Basisweiten und damit die Stromverstärkungen der an einer zu zerteilenden Halbleiterplatte gleichzeitig hergestellten bipolaren Planartransistoren, welche Schaltungskomponenten von integrierten Schaltungen sind, mit den Oxiddickenschwankungen ebenfalls entsprechenden Schwankungen unterworfen sind, wenn die Dotierungen der Basiszone nicht in zwei Implantationsprozessen bei unterschiedlichen Beschleunigungsenergien implantiert werden, wobei aber ein die Bewegung der Minoritäten hemmendes Driftfeld entsteht. Das Dotierungsmaterial für die Basiszone wird nämlich durch eine aus Siliziumoxid bestehende Isolierschicht implantiert; das Dotierungsmaterial der Emitterzone aber unmittelbar in die Halbleiteroberfläche.

Aufgabe der Erfindung ist, die Auswirkung der Isolierschichtdickenschwankungen auf die Basiszonendickenschwankungen unter der Emitterzone zu vermindern, ohne ein auf die Emitterzone gerichtetes Driftfeld zu erhalten.

Diese Aufgabe wird bei einem Verfahren gemäß dem Oberbegriff des Anspruchs 1 dadurch gelöst, daß die Dotierungen der Emitterzone durch dieselbe Isolierschicht implantiert werden wie die der Basiszone.

Da einerseits, insbesondere bei der Implantation von Arsen durch eine aus $SiO_2$ bestehende Isolierschicht eine vergleichsweise sehr geringe Isolierschichtdicke zwischen 30 und 60 nm bei 200 KV Beschleunigungsspannung zu wählen ist, sind bei dem Verfahren nach der Erfindung nach der Implantation der Basisdotierung alle diejenigen Bereiche der Isolierschicht, durch die keine Implantation solcher Ionen mit relativ großem Ionenradius erfolgt, zu verstärken. Diese Verstärkung erfolgt mit einer weiteren Isolierschicht mit einem Material, welches hinsichtlich des Materials des erstgenannten Isolierschicht selektiv ätzbar ist, welche vorzugsweise aus $SiO_2$ besteht, während als Material der weiteren Isolierschicht $Si_3N_4$ gewählt werden kann. Durch diese Verstärkung der Isolierschicht wird erreicht, daß die Auswirkungen von Fehlern oder Ungleichmäßigkeiten auf die Bereiche außerhalb der gewünschten Implantation der Ionen mit relativ großem Ionenradius unschädlich gemacht werden und die Kapazitäten zwischen Halbleiterkörper und Leiterbahnen verringert werden. Man kann somit bei Verwendung handelsüblicher Implanter ausreichend dünne Isolierschichten verwenden.

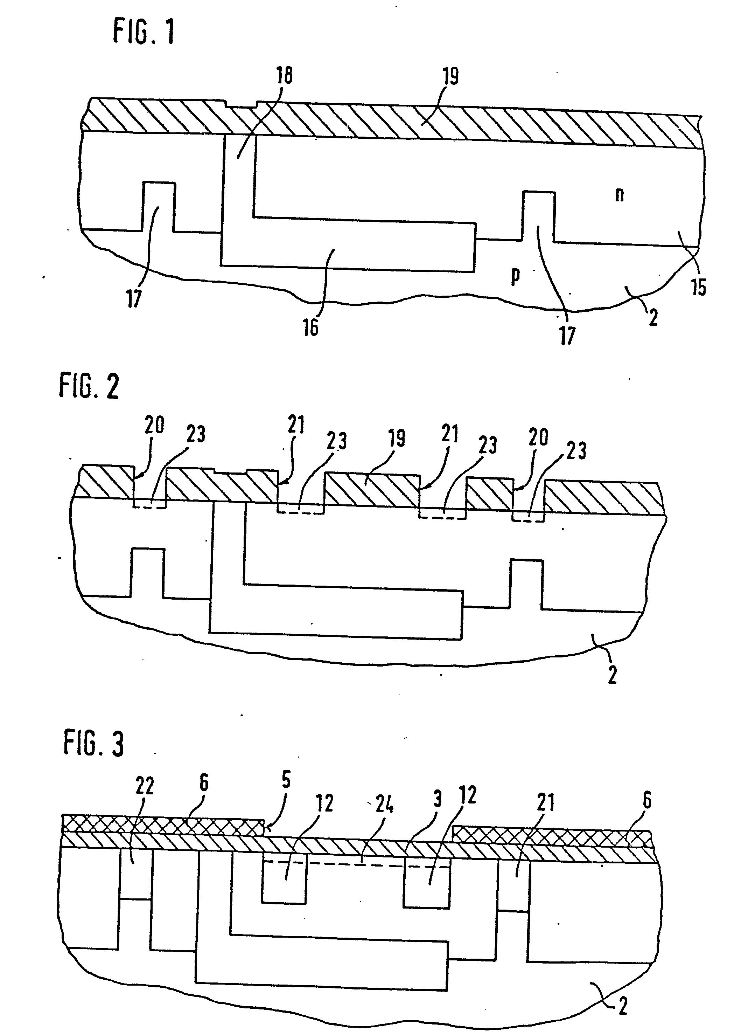

Die Erfindung wird im folgenden an einem bevorzugten Ausführungsbeispiel anhand der Zeichnung erläutert, deren Fig. 1 bis 6 zur Veranschaulichung aufeinanderfolgender Prozeßstadien entsprechend einem Ausführungsbeispiel nach der Erfindung dienen.

Die Fig. 1 zeigt in üblicher Querschnittsansicht etwa senkrecht zu einer Halbleiterplatte den Ausschnitt einer monolithisch integrierten Festkörperschaltung, in welche ein integrierter Planartransistor nach der Erfindung herzustellen ist. Bei einer Struktur gemäß der Fig. 1 wird auf einem p-leitenden Halbleiterkörper 2 eine n-leitende Epitaxialschicht 15 aufgebracht, nachdem in die freiliegende Oberfläche des Halbleiterkörpers 2 das n-dotierende Dotierungsmaterial der vergrabenen Schicht 16 und das p-dotierende Dotierungsmaterial der rahmenförmig ausgebildeten Isolierteilzone 17 eingebracht worden ist. Zur Herstellung eines niederohmigen Kollektoranschlusses an der vergrabenen Schicht 16 wird in die freie Oberfläche der Epitaxialschicht 15 mittels eines Planardiffusionsprozesses die Kollektoranschlußzone 18 eindiffundiert.

Anschließend werden, wie die Fig. 2 veranschaulicht, in der Maskierungsschicht 19 die rahmenförmige Diffusionsöffnung 20 zur Diffusion der Isolierzone 22 und die streifenförmige Diffusionsöffnung 21 zur Diffusion der Basiskontaktierungszone 12 gemäß den Fig. 3 bis 6 angebracht. Durch diese streifenförmige Basiskontaktierungszone 12 ist eine niederohmige Kontaktierung der aktiven Basiszone 11 und damit eine hohe Grenzfrequenz gewährleistet.

Durch die Öffnungen 20 und 21 gemäß der Fig. 2 erfolgt nun eine Implantation von Bor unter Bildung der Dotierungsbereiche 23, aus denen die Isolierzone 22 und die Basiskontaktierungszone 12 während eines anschließenden Aktivierungsprozesses diffundiert werden.

Auf der freigelegten Halbleiteroberfläche wird anschließend die Isolierschicht 3 mit einer möglichst einheitlichen Dicke im Bereich zwischen 30 und 60 nm erzeugt.

Zur Begrenzung der anschließend erfolgenden Implantation von Bor wird gemäß der Fig. 3 die die Öffnung 6 enthaltende erste Photolackmaskierungsschicht 6 aufgebracht, und in den unterhalb der Öffnung 5 befindlichen Oberflächenbereich des Halbleiterkörpers 2 Bor-Ionen unter Bildung des Dotierungsbereiches 24 implantiert.

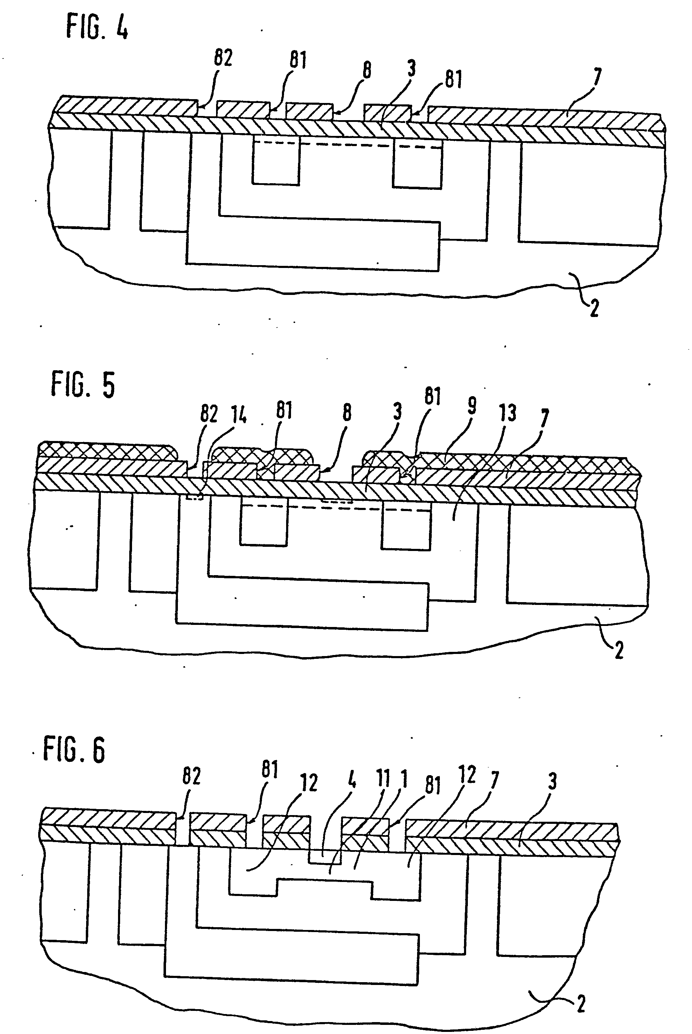

Dann wird die erste Photolackmaskierungsschicht 6 entfernt und die Isolierschicht 3 mit einer weiteren Isolierschicht 7 bedeckt, vorzugsweise aus $Si_3N_4$, welches selektiv

hinsichtlich des Materials der Isolierschicht 3 ätzbar ist, nämlich z.B. durch heiße Phosphorsäure, die $SiO_2$ praktisch nicht angreift. In der weiteren Isolierschicht 7 werden ein Fenster 8 an der Stelle der herzustellenden Emitterzone 4, zwei Basiskontaktierungsfenster 81 und das Fenster 82 an der Stelle des Kollektorkontaktierungsbereichs 14 angebracht. Die gesamte Anordnung gemäß der Fig. 4 wird mit einer zweiten Photolackmaskierungsschicht 9 bedeckt, welche an der Stelle der herzustellenden Emitterzone 4 und an der Stelle des Kollektorkontaktierungsbereichs 14 Öffnungen aufweist, wie die Fig. 5 veranschaulicht. Aus dieser Fig. 5 ist auch erkennbar, daß in Form von winzigen Löchern ausgebildete Fehler in der Isolierschicht 3 nicht stören, da die anschließend erfolgende Implantation von As-Ionen nur durch diese freigelegten Bereiche der Isolierschicht 3 erfolgen kann.

Bei einer Dicke der Isolierschicht 3 im erwähnten Bereich zwischen 30 und 60 nm sind Beschleunigungsspannungen von ca. 200 KV erforderlich. Werden anstelle von Arsenionen Phosphorionen implantiert, so ist bereits eine Beschleunigungsspannung von 100 KV ausreichend, da das Phosphorion kleiner ist als das Arsenion. Es wird jedoch Arsen als Dotierung der Emitterzone vorgezogen, da Arsen sich besser in das Si-Gitter einbaut und sich dadurch bessere elektrische Eigenschaften der Transistoren ergeben.

Es empfiehlt sich, vor dem Aufbringen der Isolierschicht 3 auf den sorgfältig freigelegten Halbleiterkörper 2 keinen Erhitzungsprozess durchzuführen, der die in die Bereiche 23 gemäß der Fig. 2 implantierten Ionen aktivieren könnte. Damit existiert noch kein PN-Übergang, dessen Feldzone vor dem Aufbringen der Isolierschicht 3 Verunreinigungen mit Dipolcharakter anziehen könnte.

Die Dicke der weiteren Isolierschicht 7 muß natürlich so bemessen sein, daß sie zusammen mit der Isolierschicht 3 als Maskierung gegen die Implantation der Arsenionen ausreicht. Der folgende Maskierungsschritt durch Aufbringen der zweiten Photolackmaskierungsschicht 9 erfordert dann keine kritische Justierung, da nur das Basiskontaktfenster 81 abzudecken ist.

Da die Kapazitäten zwischen den die Emitterzone 4, die Basiskontaktierungszone 12 und den Kollektorkontaktierungsbereich 14 kontaktierenden Leiterbahnen einerseits und dem Halbleiterkörper 2 andererseits bei einem UHF-Planartransistor möglichst klein gehalten werden sollen, ist es vorteilhaft, die weitere Isolierschicht 7 mit einer entsprechend dicken Fremdoxidschicht zu verstärken.

Da die Gesamtladungsmenge in der Basiszone unter der Emitterzone bei dem Verfahren der Erfindung unabhängig von den Oxiddickenschwankungen ist, lassen sich Stromverstärkungswerte mit geringen Schwankungen unabhängig von der Dotierung der Basiszone einstellen.

Diese Unabhängigkeit von Oxiddickenschwankungen versucht man zwar auch bei dem Verfahren der eingangs genannten europäischen Offenlegungsschrift durch zwei Basis-Implantationen mit verschiedenen Energien zu erreichen. Dieses Verfahren ist aber nur wirksam, solange man ein die Bewegung der Minoritäten hemmendes Driftfeld in der Basiszone mit in Kauf nimmt, welches aber die Hochfreguenzeigenschaften verschlechtert. Bei dem Verfahren der Erfindung vermeidet man dieses und erreicht trotzdem "konstante" B-Werte, d. h. von Oxiddickenschwankungen unabhängige B-Werte.

**Patentansprüche**

Verfahren zur Herstellung eines integrierten bipolaren Planartransistors, dessen Basiszone (1) unter Anwendung der Ionenimplantation durch eine auf einen Halbleiterkörper (2) in bestimmter Dicke und Zusammensetzung aufgebrachte Isolierschicht (3) und dessen Emitterzone (4) ebenfalls unter Anwendung der Ionenimplantation hergestellt werden, dadurch gekennzeichnet,
- daß die Dotierungen der Emitterzone (4) durch dieselbe Isolierschicht (3) implantiert werden wie die der Basiszone (1).

Verfahren nach Anspruch 1, dadurch gekennzeichnet,
- daß die Isolierschicht (3) aus einem ersten Material auf einen Halbleiterkörper (2) aufgebracht wird,
- daß durch eine Öffnung (5) in einer ersten Photolackmaskierungsschicht (6) in einen entsprechenden mit dem ersten Leitungstyp dotierten Oberflächenbereich des Halbleiterkörpers (2) Ionen des zweiten Leitungstyps mit einem relativ kleinen Ionenradius implantiert werden.
- daß dann die erste Photolackmaskierungsschicht (6) entfernt und die Isolierschicht (3) mit einer weiteren Isolierschicht (7) aus einem zweiten Material bedeckt wird, welches selektiv hinsichtlich des ersten Materials ätzbar ist,
- daß danach in der weiteren Isolierschicht (7) mindestens ein Fenster (8) mindestens an der Stelle der herzustellenden Emitterzone (4) angebracht wird und die verbleibenden Teile der weiteren Isolierschicht (7) und gegebenenfalls weitere Fenster (81) mit einer zweiten Photolackmaskierungsschicht (9) bedeckt werden,
- daß anschließend Ionen des ersten Leitungstyps mit relativ großen Ionenradien durch die freiliegenden Bereiche der Isolierschicht (3) in die Halbleiteroberfläche implantiert werden,
- daß dann die zweite Photolackmaskierungsschicht (9) entfernt wird und
- schließlich die implantierten Ionen während eines Nachdiffusionsprozesses vor oder nach Entfernung der Teile der Isolierschicht (3) innerhalb des Fensters (8) bzw. der Fenster (8, 81, 82) in der weiteren Isolierschicht (7) aktiviert werden.

Verfahren nach Anspruch 2, dadurch gekennzeichnet,
- daß durch eine Öffnung (5) in einer ersten Photolackmaskierungsschicht (6) in einen n-dotierten Oberflächenbereich eines Si-Halbleiterkörpers (2) Bor-Ionen zur Herstellung der Basiszone (1) implantiert werden,
- daß nach Aufbringen der weiteren Isolierschicht (7) in dieser ein erstes Fenster (8) an der Stelle der herzustellenden Emitterzone (4), ein zweites Fenster (81) an der Stelle eines Basiskontaktierungsbereiches und ein drittes Fenster (82) an der Stelle eines Kollektorkontaktierungsbereichs (14) angebracht werden,
- daß die verbleibenden Teile der weiteren Isolierschicht (7) und das zweite Fenster (81) an der Stelle des Basiskontaktierungsbereichs mit einer zweiten Photolackmaskierungsschicht (9) bedeckt werden und
- daß anschließend Arsen-Ionen durch die freiliegenden Bereiche der Isolierschicht (3) in die Halbleiteroberfläche implantiert werden.

4. Verfahren nach einem der Ansprüche 1 bis 3, dadurch gekennzeichnet,
- daß auf den Halbleiterkörper (2) eine Isolierschicht (3) aus $SiO_2$ aufgebracht wird und die Isolierschicht (3) mit einer weiteren Isolierschicht (7) aus $Si_3N_4$ bedeckt wird.

## Claims

1. Method of fabricating an integrated bipolar planar transistor whose base region (1) is formed by ion implantation through an insulating layer (3) of a given thickness and composition deposited on a semiconductor body (2), and whose emitter region (4) is also formed by ion implantation, characterized in
- that the dopants for the emitter region (4) are implanted through the same insulating layer (3) as those for the base region (1).

2. A method as claimed in claim 1, characterized in
- that the insulating layer (3), made of a first material, is deposited on a semiconductor body (2),
- that through an opening (5) in a first photoresist mask layer (6), ions of the second conductivity type and having a relatively small ionic radius are implanted into a portion of the surface of the semiconductor body (2) which portion is doped so as to be of the first conductivity type,
- that the first photoresist mask layer (6) is then removed, and that the insulating layer (3) is covered with an additional insulating layer (7) cont'd. made of a second material which is etchable selectively with respect to the first material,
- that at least one window (8) is then opened in the additional insulating layer (7) at least where the emitter region (4) is to be formed, and the remaining portions of the additional insulating layer (7) and any further windows (81) are covered with a second photoresist mask layer (9),
- that ions of the first conductivity type and having a relatively great ionic radius are then implanted into the semiconductor surface through the exposed portions of the insulating layer (3),
- that the second photoresist mask layer (9) is then removed, and
- that the implanted ions are activated during a postdiffusion process prior to or after the removal of the portions of the insulating layer (3) within the window (8) or windows (8, 81, 82) in the additional insulating layer (7).

3. A method as claimed in claim 2, characterized in
- that boron ions for forming the base region (1) are implanted through an opening (5) in a first photoresist mask layer (6) into an n-type surface area of an Si semiconductor body (2),
- that, after deposition of the additional insulating layer (7), the latter is provided with a first window (8) where the emitter region (4) is to be formed, a second window (81) where a base contact region is to be formed, and a third window (82) where a collector contact region (14) is to be formed,
- that the remaining portions of the additional insulating layer (7) and the second window (81) are covered with a second photoresist mask layer (9), and
- that arsenic ions are then implanted into the semiconductor surface through the exposed areas of the insulating layer (3).

4. A method as claimed in any one of claims 1 to 3, characterized in
- that an insulating layer (3) of $SiO_2$ is formed on the semiconductor body (2) and covered with an additional insulating layer (7) of $Si_3N_4$.

## Revendications

1. Procédé de fabrication d'un transistor planar bipolaire intégré, dont la zone de base (1) est produite par implantation ionique au travers d'une couche isolante (3) d'une épaisseur et d'une composition données déposée sur un corps semi-conducteur (2) et dont la zone d'émetteur (4) est également produite par implantation ionique, caractérisé en ce que: - le dopage de la zone d'émetteur (4) est réalisé par implantation au travers de la même couche isolante (3) que celle utilisée pour la zone de base (1).

2. Procédé selon la revendication 1 caractérisé en ce que:
- la couche isolante (3), formée d'un premier matériau, est déposée sur un corps semi-conducteur (2),
- au travers d'une ouverture (5) d'une couche de laque de masquage photosensible (6), des ions d'un second type de conductibilité ayant un rayon ionique relativement petit sont implantés dans une portion de la face supérieure du corps semi-conducteur (2) dopée de manière à êtredu premier type de conductibilite,

- la première couche de laque de masquage photosensible (6) est ensuite enlevée, la couche isolante (3) est recouverte par une couche isolante (7) supplémentaire formée d'un second matériau qui est sensible à l'attaque sélective par rapport au premier matériau,

- au moins une fenêtre (8) est alors ouverte dans la couche isolante supplémentaire (7), au moins dans la région où doit être réalisée la zone d'émetteur (4), les portions restantes de la couche isolante supplémentaire et tout autre fenêtre supplémentaire (81) étant recouvertes par une seconde couche de laque de masquage photosensible (9),

- des ions du premier type de conductibilité et ayant un rayon ionique relativement grand sont ensuite implantés dans la face supérieure du semi-conducteur, au travers de la région dégagée de la couche isolante (3),

- la deuxième couche de laque de masquage photosensible (9) est ensuite enlevée, et en ce que

- en dernier lieu, les ions implantés sont activés au cours d'un processus de postdiffusion, avant ou après avoir ôté les parties de la couche isolante (3) à l'intérieur de la fenêtre (8), ou des fenêtres (8, 81, 82), de la couche isolante supplémentaire (7).

3. Procédé selon la revendication 2 caractérisé en ce que:

- pour former la zone de base (1), des ions de bore sont implantés au travers d'une ouverture (5), formée dans une première couche de laque de masquage photosensible (6), dans la face supérieure de type N d'un corps semi-conducteur en silicium (2),

- après avoir déposé la couche isolante supplémentaire (7), on forme dans cette dernière une première fenêtre (8) en vis à vis de la zone d'émetteur (4), une seconde fenêtre (81) en vis à vis de la zone de contact de la base, et une troisième fenêtre (82) en vis à vis de la zone de contact du collecteur (14),

- les portions restantes de la couche isolante supplémentaire (7) et la seconde fenêtre (81) en vis à vis de la zone de contact de la base, sont recouvertes avec une seconde couche de laque de masquage photosensible, et en ce que

- des ions arseniques sont alors implantés à la surface du semi-conducteur, à travers les régions dégagées de la couche isolante(3).

4. Procédé selon l'une des revendications 1 à 3 caractérisée en ce que:

- une couche isolante (3) de $Si O_2$ est formée sur le corps semi-conducteur (2), et en ce que la couche isolante (3) est recouverte avec une couche isolante supplémentaire (7) de $Si_3 N_4$.

FIG. 1

FIG. 2

FIG. 3

FIG. 4

FIG. 5

FIG. 6